# EUROPEAN PATENT SPECIFICATION

(11) **EP 0 385 142 B1**
(45) Date of publication and mention of the grant of the patent: **27.09.1995**
(21) Application number: 90102348.1
(22) Date of filing: 07.02.1990
(51) Int. Cl.: H01R 13/02, H01R 23/72, H01R 9/09, H01R 4/02

(54) **Electrical connecting apparatus**
Elektrische Verbindungsvorrichtung
Dispositif de connexion électrique

(30) Priority: 28.02.1989 JP 21289/89 U; 17.03.1989 JP 66814/89
(43) Date of publication of application: 05.09.1990
(73) Proprietor: FUJITSU LIMITED, Kawasaki-shi, Kanagawa 211 (JP)
(72) Inventor: Tsuji, Hiroki, Yokohama-shi, Kanagawa 227 (JP); Kawano, Kyoichiro, Yokohama-shi, Kanagawa 227 (JP); Murase, Teruo, Yokohama-shi, Kanagawa 247 (JP)
(74) Representative: Seeger, Wolfgang, Dipl.-Phys.

(56) References cited:
- DE-A- 2 652 506
- JP-A-58 130 540
- US-A- 3 023 393
- US-A- 3 622 944
- US-A- 3 702 500

## Description

### BACKGROUND OF THE INVENTION

### (1) Field of the Invention

The present invention relates to an electrical connector. Recent progress of computer systems toward higher performance requires the printed circuit boards used in the system to be in such a trend as realizing reduction in size and high packing density.

With such trend, a lot of input/output I/O pins have been implanted on one printed circuit board.

An attempt of connecting such large amount of I/O pins provided on the circuit board using the conventional male-female connectors in order to electrically connect these printed circuit boards will require a large amount of force. As a result, a large force is applied on the printed circuit board when the male connector is fitted, bringing about a problem that a warpage is generated on the circuit board or in some cases the printed circuit board may be broken.

Moreover, in such a tendency, electronic parts such as semiconductor elements have been mounted on the printed circuit board in the form of a bare chip. However, the printed circuit board mounting such electronic elements is generally formed by ceramic materials. Therefore, the pads provided at the predetermined regions of the bare chip of electronic part are connected by solder with the pads provided at the predetermined regions of ceramic circuit board, but the difference of the expansion coefficients between the ceramic substrate and the bare chip is large. Therefore, when a bare chip is loaded on the printed circuit board, mechanical stress is generated at the junction area between electronic parts and printed circuit board due to temperature change at the time of power ON and OFF and thereby cracks may sometimes be generated at the junction area (solder).

### (2) Description of the Prior Art

It is a countermeasure for such problems to use liquid metal for the contact area. This method is for example disclosed in the patents; ① Japanese Laid-open patent No. 52-73392 (H.Tsuji and K.Kawano), ② Japanese Laid-open patent No. 60-253177 (M.Yasunaga and K.Sato), ③ Japanese Laid-open Patent No. 58-130540 (H.Doi et al.). In the patent ① , the contact (meaning the junction area) is formed by a flexible material impregnated by liquid metal and the male-female connector is connected through this contact area. In the patent ② a metal which is of the solid condition when not used is heated and converted to liquid metal and electrical connection is formed by inserting electrodes to such liquid metal.

However, metal used for the contact of the patent ① is always liquid and the liquid metal splashes and is disabled while the terminal is repeatedly fitted and removed. The patent ② has a disadvantage that the liquid metal splashes and is consumed like in the patent① due to fitting and removal of electrodes and moreover a heating apparatus must be provided additionally for melting the solid metal.

In the patent ③, balls of liquid metal or liquid alloy are adhered, under room temperature, to a plurality of first pads provided at the predetermined surfaces of electronic parts on the occasion of mounting electronic parts on the printed circuit board and the first pads are positioned so that these balls match a plurality of second pads provided on the mounting surface of the printed circuit board. However, the procedures for forming a lot of liquid balls and adhering these balls to the first pads cannot be done easily.

As described above, a conventional electrical connector cannot ensure reliable connection and efficiency of mounting job using such connector is low.

US-A-3622944 discloses an electrical connector in which the electrical connection is made through a low melting point alloy consisting essentially of gallium and indium which is liquid at room temperature. The contact points in this connector are made of porous solid material impregnated with the low melting point alloy.

### SUMMARY OF THE INVENTION

It is an object of the present invention to provide a highly reliable electrical connector.

It is another object of the present invention to provide an electrical connector which ensures high mounting efficiency.

These objects are achieved by the connecting apparatus as defined in claim 1. A particular embodiment of this apparatus is set out in claim 2.

The one connecting object for electrical connection is provided with a connecting pad, while the other connecting object is provided with a contact having a spring means. A porous metal layer is respectively formed to each end face of connecting pad and contact. These porous metal layers are respectively impregnated with two kinds of metals which may generate an eutectic mixture. These two kinds of metals are generally solids at room temperature (25°C ). However, when these metals are in contact, these metals mutually diffuse and form an alloy, generating an eutectic mixture. If two kinds of metals are selected so that the eutectic point, namely, the temperature at which the eutectic mixture is produced, is 20 °C or less, the liquid portion under the room temperature may be generated at the contact portion of such metals. In this case, since two kinds of metals are respectively impregnated to porous metal layers, diffusion and melting of two kinds of metals are generated only in the region near the contact area of such two kinds of metals. In this method, an excessive force is unnecessary because electrical connection is established only with placing in contact the connecting pad and contact. In addition, since only a little amount of liquid alloy exists at the junction area establishing the electrical connection, the metal impregnated to the porous metal layer recovers almost to the condition before contact for each separation of connecting pad and contact making off the electrical connection. Therefore, the metal is not consumed and may be used for a long period of time.

Otherwise, the pad of the one connecting object for electrical connection is provided with a fixed solid metal member under the room temperature, while the pad of the other connecting object is provided with a metal layer which forms an eutectic alloy in cooperation with the metal described above. When these two kinds of metals are in contact, the metal layer melts into the metal member forming an alloy and thereby the liquid alloy under the room temperature may be formed at the junction area. In such a method, it is easy to fix the metal member to the pad of the one connecting object since it is of the solid under the room temperature and the liquid metal is generated at the contact area when these two connecting objects are placed in contact with each other. Therefore, the electrical connector manufacturing efficiency may be so far improved in comparison with the conventional connector.

As explained previously, the method of the present invention solves the existing problems and achieves the above objects.

### BRIEF DESCRIPTION OF THE DRAWINGS

Fig. 1 is a schematic sectional view of a connecting apparatus for electrical connection;
Fig. 2 is a schematic enlarged view of a part A in Fig. 1 of contact area of the connecting pad and contact in the separated condition;
Fig. 3 is a schematic enlarged view of a part A in Fig. 1 of contact area of the connecting pad and contact in the contact condition; Fig. 4 is a schematic enlarged view of the part B in Fig. 2; Fig. 5 is a schematic enlarged view of the part C in Fig. 3; Fig. 6(a) is a schematic diagram of the structure wherein electronic parts are mounted on the printed circuit board;
Fig. 6(b) is a schematic diagram indicating the mounting step for providing pads of electronic parts and spacers adjacent to the pads;
Fig. 6(c) is a schematic diagram indicating the mounting step for fixing a metal member to the pad of electronic part and fixing a solder to the spacer by soldering temporally;
Fig. 6(d) is a schematic diagram indicating the mounting step for providing a connecting pad matching with the spacer of electronic part to the mounting surface wherein the pads of printed circuit board are arranged;
Fig. 6(e) is a schematic diagram indicating the mounting step for forming a metal layer, which generates an alloy with a metal member fixed to the pad of electronic part, to the pad of printed circuit board; and
Fig. 6(f) is a schematic diagram indicating the step having completed the mounting by mounting electronic parts to the mounting surface of the printed circuit board, making the positioning by matching the spacer to the connecting pad and then pressing electronic parts to the printed circuit board with predetermined pressure.

### DESCRIPTION OF THE PREFERRED EMBODIMENTS

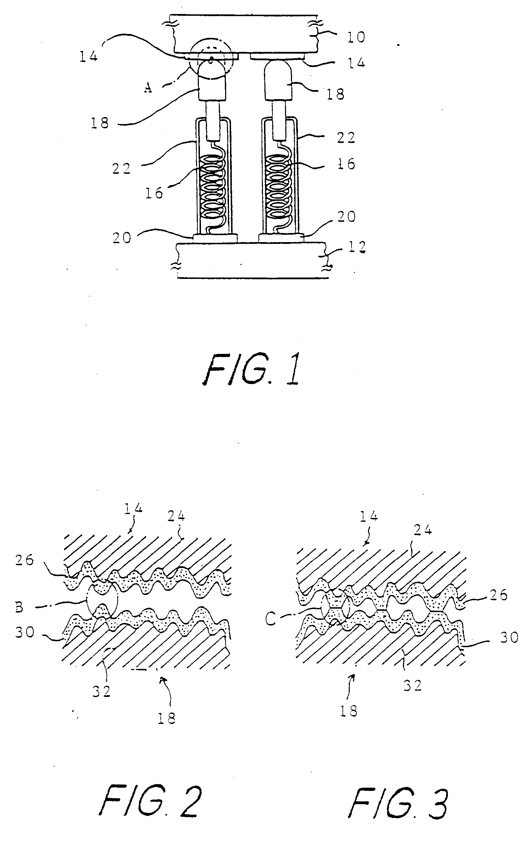

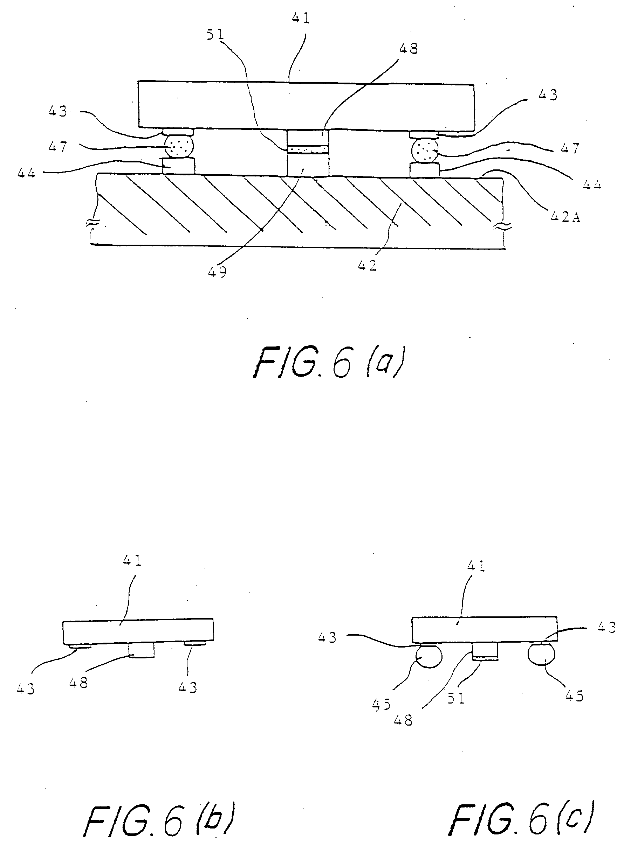

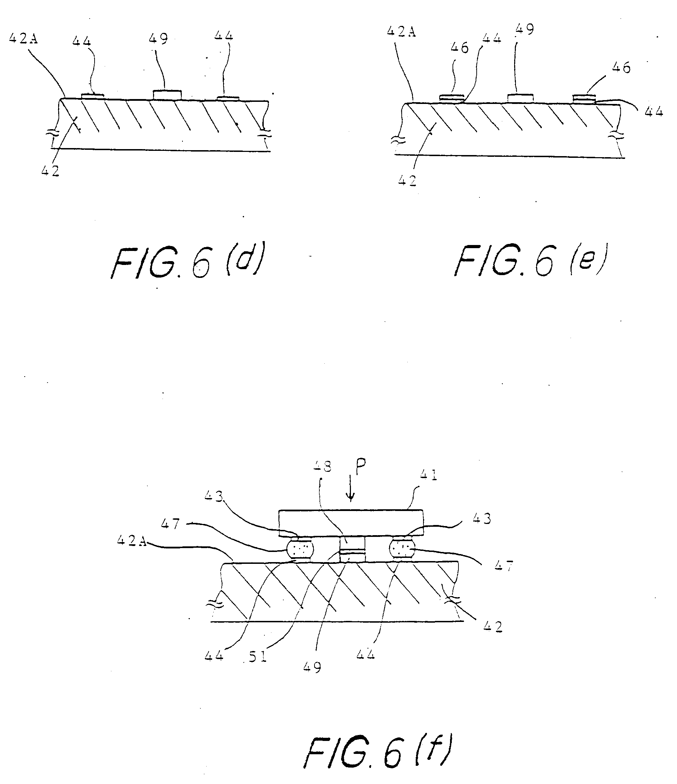

A couple of embodiments of the present invention will be explained hereunder with reference to the drawings Fig. 1 ∼ Fig. 6(f).

### First Embodiment

Fig. 1 to Fig. 5 are diagrams for explaining the first embodiment and the like reference numerals indicate the like materials and elements in these figures.

Fig. 1 is a schematic sectional view of the connecting apparatus which establishes electrical connection. The connecting apparatus shown in this figure realizes electrical connection of the printed circuit boards 10 and 12 provided opposed to each other. The one printed circuit board 10 may be a daughter board mounting a lot of LSIs, while the other printed circuit board 12 may be a mother board mounting a plurality of daughter boards. The printed circuit board 10 is provided with a connecting pad 14 and the printed circuit board 12 with a pad 20 having electrical conductivity at the location opposed to the connecting pad 14. Moreover, a coil spring 16 having electrical conductivity and small spring constant is provided to the pad 20 and a contact 18 having electrical conductivity is also provided to the coil spring 16 in contact with the connecting pad 14. The coil spring 16 is accommodated within a cylindrical capsule 22 and can be expanded or compressed in the longitudinal direction of capsule 22. Function of the coil spring 16 causes the contact 18 to be in contact with the connecting pad 14.

Fig. 2 and Fig. 3 are enlarged schematic view of the contact area A between the contact 18 and connecting pad 14 in Fig. 1. Fig. 2 is an enlarged schematic view of a part of connecting pad and contact separated each other. The connecting pad 14 is formed by coating the surface of copper (Cu) as the base material 24 with the porous silver plating layer 26. The contact 18 is formed by coating the surface of copper as the base material 32 with the porous silver plating layer 30. These porous silver plating layer may be formed, for example, by the large current electroplating. Fig. 3 is an enlarged schematic view of a part of the contact area A between the connecting pad and contact in the contact condition. The contact condition is attained at the partial area of both porous silver plating layer 26 and the porous silver plating area 30.

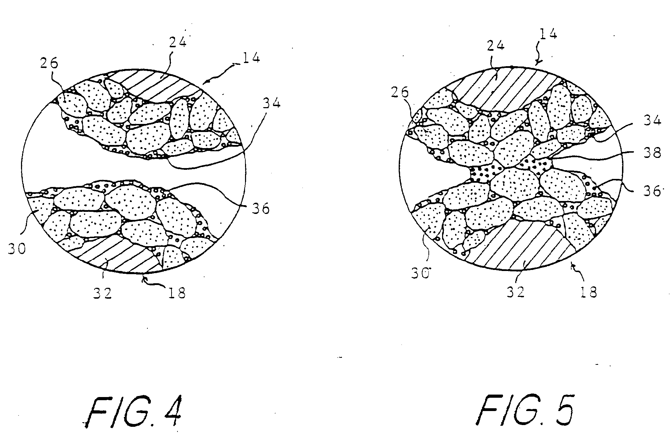

The enlarged schematic view of the area B in Fig. 2 is shown in Fig. 4. The enlarged schematic view of the area C in Fig. 3 is shown in Fig. 5. Fig. 4 is a schematic diagram of the structures of porous silver plating layer 26 and porous silver plating layer 30.

The tin-zinc alloy (Sn-Zn alloy) 34 is impregnated into the porous silver plating layer 26. Meanwhile, gallium 36 is impregnated into the porous silver plating layer 30.

When the connecting pad 14 and contact 18 are placed in contact with each other, as shown in Fig. 5, the tin-zinc alloy 34 and gallium impregnated respectively to the porous silver plating layers 26 and 30 in the area near the contact area diffuse each other and as a result, an alloy 38 having the melting point of about 10°C is generated. However, since the silver plating layers 26 and 30 are porous, mutual diffusion of tin-zinc alloy 34 and gallium 36 in the area other than that near the contact area is interfered and the alloy 38 with the melting point of about 10°C is no longer generated. Namely, the greater part of impregnated metal in the respective silver plating layers stays as before placing in contact.

Therefore, in this embodiment, the contact of connecting pad 14 and contact 18 is established by contact achieved by a very little amount of liquid alloy.

In case the connecting pad 14 and contact 18 connected are to be separated, since a volume of alloy 38 is very small in comparison with the volume of impregnated metal, the tin-zinc alloy in the alloy 38 diffuses to gallium 36 in the side of contact 18, while gallium diffuses to the tin-zinc alloy 34 in the side of connecting pad 14. As a result, the liquid alloy disappears. Accordingly, the tin-zinc alloy 34 and gallium 36 impregnated to the silver plating layers 26 and 30 respectively return to the conditions almost same as that before contact by separation between the connecting pad 14 and contact 18.

As described above, this embodiment discloses a connecting apparatus which is especially effective, for example, for the electrical connection between the printed circuit board and mother board, which is often required to make connection and disconnection.

In addition, the silver plating layer is used as the porous layer in this embodiment, but metals such as nickel (Ni) or palladium (Pd) which do not easily generate alloy with a low melting point metal such as gallium may be used. As the low melting point metal, combination of low melting point metals such as gallium-indium and gallium-indium-tin alloy may also be applicable instead of gallium.

Moreover, in this embodiment, the contact 18 is placed in contact with the connecting pad 14 by the spring means 16 but any kind of means may also be employed so long as these can be placed in contact. The printed circuit boards 10 and 12 are mechanically coupled at the end portions thereof.

### Second Embodiment

Unlike the first embodiment, this embodiment is effectively applied to the structure which does not remove electrical connection when the desired electrical connection is once achieved.

Fig. 6(a) is a schematic diagram of the structure where electronic elements are mounted on the printed circuit board 42. The liquid alloy, generated through the process that the metal member 45 fixed to the first pad 43 of electronic part 41 and the metal layer 46 stacked to the second pad 44 of the printed circuit board 42 are placed in contact with each other and then converted to alloy, forms the contact 47.

In addition, the spacer 48 is provided at the predetermined area of electronic part 41 and the connecting pad 49 on the printed circuit board 42. These spacer 48 and connecting pad 49 are connected by solder 51, positioning the first pad 43 and the second pad 44.

The mounting processes to form electrical connectors shown in Fig. 6(a) will be explained hereunder.

First, as shown in Fig. 6(b), the spacer 48 is provided adjacent to the first pad 43 to the electronic part 41 to be mounted. Then, as shown in Fig. 6(c), the predetermined amount of metal member 45 such as gallium is fixed to the first pad 43 and the solder 51 is fixed to the spacer 48 by temporally soldering. In case gallium is used as the metal member 45, it may be handled easily since gallium is in the solid state at the temperature of 25°C. Moreover, it may be fixed to the first pad 43 through application of a little amount of heat.

Meanwhile, as shown in Fig. 6(d), the printed circuit board 42 is provided with the connecting pad 49 matching with the spacer of electronic part 41 at the mounting surface 42A thereof on which the second pad 44 is arranged. As shown in Fig. 6(e), a metal layer 46, which generates an alloy with the metal member 45 is formed to the second pad 44 by the well known method such as evaporation. In case the metal member 45 is formed by gallium, it is preferable to form the metal layer 46 with tin or indium.

Next, as shown in Fig. 6(f), after the electronic part 41 is mounted on the mounting surface 42A of the printed circuit board 42 and positioning is carried out by providing the spacer 48 matching with the connecting pad 49, the electronic part 41 is pressed with the predetermined pressure p to the printed circuit board 42 and a reasonable amount of heat is applied thereto. Thereby, the metal layer 46 melts into the metal member 45, forming an alloy 47. This alloy generated has the melting point lower than any melting point of the metal member 45 and metal layer 46 and is in the liquid condition at the room temperature (25 °C ) .

Therefore, the contact 47 is formed by the liquid alloy at the room temperature (25°C ) between the first pad 43 and the second pad 44, this contact 47 establishes electrical connection between the first pad 43 and second pad 44 and meanwhile the spacer 48 is fixed to the connecting pad 49 by the solder 51.

In case gallium is used for the metal member 45 and tin is used for the metal layer 46, the melting point of gallium-tin alloy 47 generated is about 20°C. On the other hand, in case gallium is used for metal member 45 and indium is used for metal layer 46, the melting point of gallium-tin alloy generated is also about 20 °C.

As explained above, an electronic part 41 forming the electrical connection by the contact 47 with liquid alloy between the first pad 43 and second pad 44 is supported on the printed circuit board by the spacer 48 fixed to the connecting pad 49. In this case, no stress is generated at the contact 47 due to temperature change between the power ON and OFF conditions of the electronic part. Moreover, since the spacer 48 is provided at almost the symmetrical center of electronic part, stress is cancelled during both periods of expansion and compression and thereby, a large stress is no longer generated at the contact formed by the solder 51.

## Claims

1. A connecting apparatus for electrically connecting a first object (10) and a second connecting object (12) opposed to each other, said connecting apparatus comprising:
a first metal (34) having a first melting point higher than room temperature provided at the first connecting object (10);
a second metal (36) having a second melting point higher than room temperature provided at the second connecting object (12), wherein said second metal generates an alloy (38) having a third melting point lower than room temperature when it is in contact with said first metal;
a first porous metal layer (26) impregnated with said first metal (34); and
a second porous metal layer (30) provided opposed to said first porous metal layer (26) and impregnated with said second metal (36) wherein said first metal impregnated to said first porous metal layer is tin-zinc alloy and said second metal impregnated to said second porous metal layer is selected from the group consisting of gallium, gallium-indium alloy, gallium-indium-tin alloy and other low melting point metals.

2. A connecting apparatus according to claim 1, wherein said connecting apparatus comprises:
a connecting pad (49) provided at a predetermined position on said second connecting object; and
a spacer (48) provided at a predetermined position on said first connecting object which is positioned and fixed to said connecting pad in case said first connecting object and the second connecting object are mutually connected.

## Patentansprüche

1. Eine Verbindungsvorrichtung zum elektrischen Verbinden eines ersten Objektes (10) und eines zweiten Verbindungsobjektes (12), die einander gegenüberliegen, wobei diese Verbindungsvorrichtung umfaßt:
ein erstes, am ersten Verbindungsobjekt (10) vorgesehenes Metall (34) mit einem ersten Schmelzpunkt oberhalb der Raumtemperatur,
ein zweites, am zweiten Verbindungsobjekt (12) vorgesehenes Metall (36) mit einem zweiten Schmelzpunkt oberhalb der Raumtemperatur, wobei dieses zweite Metall eine Legierung (38) mit einem dritten Schmelzpunkt unterhalb der Raumtemperatur bildet, wenn es in Kontakt mit diesem ersten Metall ist;
eine erste, mit diesem ersten Metall (34) imprägnierte poröse Metallschicht (26); und
eine zweite poröse Metallschicht (30), welche dieser ersten porösen Metallschicht (26) gegenüberliegt und mit diesem zweiten Metall (36) imprägniert ist, wobei dieses erste, die erste poröse Metallschicht imprägnierende Metall eine Zinn-Zink-Legierung ist, und wobei dieses zweite, die zweite poröse Metallschicht imprägnierende Metall aus der Gruppe ausgewählt wird, die Gallium, eine Gallium-Indium-Legierung, eine Gallium-Indium-Zinn-Legierung und andere Metalle mit niedrigem Schmelzpunkt umfaßt.

2. Eine Verbindungsvorrichtung nach Anspruch 1, wobei diese Verbindungsvorrichtung umfaßt:
ein an einer vorgegebenen Position an diesem zweiten Verbindungsobjekt angeordnetes Anschlußpad (49); und
einen Abstandhalter (48), der an einer vorgegebenen Position an diesem ersten Verbindungsobjekt angeordnet ist und welcher zu das Anschlußpad positioniert und mit diesem verbunden wird, wenn das erste Verbindungsobjekt und das zweite Verbindungsobjekt miteinander verbunden werden.

## Revendications

1. Dispositif de connexion pour connexion électrique d'un premier objet à connecter (10) et d'un second objet à connecter (12) en face l'un de l'autre, ledit dispositif de connexion comprenant :
un premier métal (34), ayant un premier point de fusion plus élevé que la température ambiante, placé au droit du premier objet à connecter (10) ;
un second métal (36), ayant un deuxième point de fusion plus élevé que la température ambiante, placé au droit du second objet à connecter (12) ; ledit second métal produisant un alliage (38) ayant un troisième point de fusion plus bas que la température ambiante lorsqu'il est en contact avec ledit premier métal ;
une première couche métallique poreuse (26) imprégnée dudit premier métal (34) ; et
une seconde couche métallique poreuse (30) placée en face de ladite première couche métallique poreuse (26) et imprégnée dudit second métal (36) ;
dans lequel ledit premier métal imprégnant ladite première couche métallique poreuse est un alliage d'étain-zinc et ledit second métal imprégnant ladite seconde couche métallique poreuse est choisi dans le groupe constitué du gallium, des alliages de galliumindium, des alliages de gallium-indium-étain et autres métaux à bas point de fusion.

2. Dispositif de connexion selon la revendication 1, dans lequel ledit dispositif de connexion comprend :
un plot de connexion (49) placé dans une position prédéterminée sur ledit second objet à connecter ; et
un écarteur (48) placé dans une position prédéterminée sur ledit premier objet à connecter qui est placé sur ledit plot de connexion et fixé à celui-ci, lorsque ledit premier objet à connecter et ledit second objet à connecter sont mutuellement connectés.
